# EUROPÄISCHE PATENTSCHRIFT

(11) **EP 1 100 016 B1**
(45) Veröffentlichungstag und Bekanntmachung des Hinweises auf die Patenterteilung: **03.12.2003**
(21) Anmeldenummer: 00122818.8
(22) Anmeldetag: 20.10.2000
(51) Int. Cl.: G06F 11/20

(54) **Speichereinrichtung mit Ersatz-Speicherzellen**
Memory device with replacement memory cells
Dispositif de mémoire avec des cellules de mémoire de remplacement

(30) Priorität: 11.11.1999 DE 19954345
(43) Veröffentlichungstag der Anmeldung: 16.05.2001
(73) Patentinhaber: Infineon Technologies AG, 81669 München (DE)
(72) Erfinder: Sellmair, Gerald, 84036 Landshut (DE); Bartl, Andrea, 81667 München (DE)
(74) Vertreter: Wilhelm, Jürgen, Dipl.-Phys.

(56) Entgegenhaltungen:
- EP-A- 0 239 196
- EP-A- 0 343 344
- US-A- 5 034 925
- PATENT ABSTRACTS OF JAPAN vol. 018, no. 473 (P-1795), 2. September 1994 (1994-09-02) & JP 06 150689 A (NEC CORP), 31. Mai 1994 (1994-05-31)

## Beschreibung

Die vorliegende Erfindung betrifft Vorrichtungen gemäß den Oberbegriffen der Patentansprüche 1 und 2, d.h. eine Speichereinrichtung mit einer Vielzahl von Speicherzellen zum Speichern von Daten, mit mindestens einer Vergleichseinheit, durch welche überprüfbar ist, ob einer an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt, und mit einer Auswahleinrichtung, welche bei Bedarf dafür sorgt, daß anstelle von nicht ordnungsgemäß beschreibbaren oder auslesbaren Speicherzellen oder Speicherzellenbereichen Ersatz-Speicherzellen oder Ersatz-Speicherzellenbereiche verwendet werden.

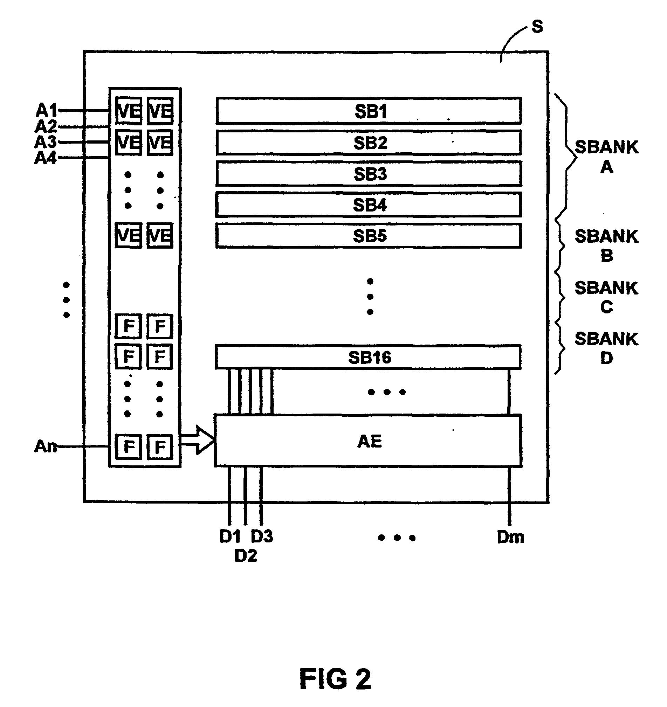

Eine Speichereinrichtung dieser Art ist schematisch in der Figur 2 dargestellt. Der Vollständigkeit halber sei darauf hingewiesen, daß in der Figur 2 nur die vorliegend besonders interessierenden Bestandteile der Speichereinrichtung gezeigt sind.

Die Speichereinrichtung ist in der Figur 2 mit dem Bezugszeichen S bezeichnet.

Die Speichereinrichtung S ist im betrachteten Beispiel zur Speicherung von 16 MBit Daten ausgelegt, weist also mindestens 16M Speicherzellen auf. Die vorhandenen Speicherzellen sind im betrachteten Beispiel auf 16 gleich große, also in zur Speicherung von jeweils 1 MBit Daten ausgelegte Speicherblöcke SB1 bis SB16 verteilt. Diese Speicherblöcke SB1 bis SB16 sind im betrachteten Beispiel wiederum auf vier gleich große Speicherbänke SBankA, SBankB, SBankC, und SBankD verteilt.

Die Speicherzellen eines jeden Speicherblocks sind im betrachteten Beispiel in einer 512 Zeilen und 2048 Spalten umfassenden Speicherzellen-Matrix angeordnet, also über 512 Wortleitungen und 2048 Bitleitungen ansprechbar. Die Maßnahmen, die im einzelnen zu ergreifen sind, um ausgewählte Speicherzellen zu beschreiben oder auszulesen, sind allgemein bekannt und bedürfen keiner näheren Erläuterung.

Die jeweils zu beschreibenden oder auszulesen Speicherzellen werden durch eine an die Speichereinrichtung angelegte, genauer gesagt an Anschlüsse A1 bis An derselben angelegte Adresse bestimmt; die Daten, die in die betreffenden Speicherzellen einzuschreiben sind, bzw. die aus den betreffenden Speicherzellen auszulesen sind, werden an Anschlüsse D1 bis Dm der Speichereinrichtung angelegt bzw. zur Abholung bereitgestellt.

Die betrachtete Speichereinrichtung weist mehr als die 16M Speicherzellen auf, die erforderlich sind, um 16 MBit Daten zu speichern. Dies wird gemacht, um nicht ordnungsgemäß beschreibbare oder auslesbare Speicherzellen oder Speicherzellenbereiche durch andere Speicherzellen oder Speicherzellenbereiche ersetzen zu können.

Die Speicherzellen oder Speicherzellenbereiche, die nicht ordnungsgemäß beschreibbar oder auslesbar sind, genauer gesagt die diesen Speicherzellen oder Speicherzellenbereichen zugeordneten Adressen werden bei einem Test der Speichereinrichtung ermittelt und beispielsweise unter Verwendung von sogenannten Fuses F in der Speichereinrichtung registriert.

Im normalen Betrieb der Speichereinrichtung werden die über die Anschlüsse A1 bis An der Speichereinrichtung an diese angelegten Adressen mit den in der Speichereinrichtung registrierten Adressen der nicht ordnungsgemäß beschreibbaren oder auslesbaren Speicherzellen oder Speicherzellenbereiche durch Vergleichseinheiten VE verglichen. Wenn sich bei einem solchen Vergleich eine Übereinstimmung ergibt, so wird dies einer Auswahleinrichtung AE signalisiert, und diese sorgt dafür, daß in die Speichereinrichtung einzuschreibende Daten nicht etwa in die Speicherzellen eingeschrieben werden, die durch die an die Speichereinrichtung angelegte Adresse bezeichnet werden, sondern in den nicht verwendbaren Speicherzellen zugeordnete (Ersatz-)Speicherzellen, bzw. daß aus der Speichereinrichtung auszulesende Daten nicht etwa aus den Speicherzellen ausgelesen werden, die durch die an die Speichereinrichtung angelegte Adresse bezeichnet werden, sondern aus den nicht verwendbaren Speicherzellen zugeordneten (Ersatz-)Speicherzellen.

Auf die beschriebene Art und Weise können Speichereinrichtungen, in welchen nicht alle Speicherzellen ordnungsgemäß beschreibbar und auslesbar sind, wie völlig fehlerfreie Speichereinrichtungen verwendet werden; der Benutzer der Speichereinrichtung merkt nichts davon, daß bestimmte Speicherzellen oder Speicherzellenbereiche durch Ersatz-Speicherzellen oder Ersatz-Speicherzellenbereiche ersetzt werden.

Allerdings sind die Überprüfung, ob die gerade zu beschreibenden oder auszulesenden Speicherzellen oder Speicherzellenbereiche durch Ersatz-Speicherzellen bzw. Ersatz-Speicherzellenbereiche ersetzt werden müssen, und das Ersetzen der nicht verwendbaren Speicherzellen oder Speicherzellenbereiche mit einem nicht unerheblichen Aufwand verbunden und/oder beschränken oder verringern die Geschwindigkeit, mit welcher Daten in die Speichereinrichtung eingeschrieben oder aus dieser ausgelesen werden können.

Der vorliegenden Erfindung liegt daher die Aufgabe zugrunde, die Speichereinrichtung gemäß den Oberbegriffen der Patentansprüche 1 und 2 derart weiterzubilden, daß sich das Erkennen von Zugriffen auf nicht ordnungsgemäß beschreibbare oder auslesbare Speicherzellen oder Speicherzellenbereiche und das Ersetzen dieser Speicherzellen oder Speicherzellenbereiche mit minimalem Aufwand maximal schnell bewerkstelligen läßt.

Diese Aufgabe wird erfindungsgemäß durch die im kennzeichnenden Teil des Patentanspruchs 1 und/oder die im kennzeichnenden Teil des Patentanspruchs 2 beanspruchten Merkmale gelöst.

Demnach ist vorgesehen,
- daß der Auswahleinrichtung bereits zu einem Zeitpunkt, zu dem noch nicht feststeht, daß der an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt, Informationen über die Lage der nicht zu verwendenden Speicherzellen oder Speicherzellenbereiche zugeführt werden (kennzeichnender Teil des Patentanspruchs 1), und/oder
- daß der Auswahleinrichtung bereits vor dem Zeitpunkt, zu dem sie veranlaßt wird, dafür zu sorgen, daß anstelle von nicht ordnungsgemäß beschreibbaren oder auslesbaren Speicherzellen oder Speicherzellenbereichen Ersatz-Speicherzellen oder Ersatz-Speicherzellenbereiche verwendet werden, Informationen über die Lage der nicht zu verwendenden Speicherzellen oder Speicherzellenbereiche zugeführt werden (kennzeichnender Teil des Patentanspruchs 2).

Dadurch kann die Auswahleinrichtung nach der Feststellung, daß der an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt, sofort damit beginnen, die nicht verwendbaren Speicherzellen oder Speicherzellenbereiche durch Ersatz-Speicherzellen oder Ersatz-Speicherzellenbereiche zu ersetzen; die von der Auswahleinrichtung hierzu benötigten Informationen über die Lage der nicht zu verwendenden Speicherzellen oder Speicherzellenbereiche liegen der Auswahleinrichtung zu diesem Zeitpunkt bereits vor.

Bei Speichereinrichtungen dieser Art lassen sich das Erkennen von Zugriffen auf nicht ordnungsgemäß beschreibbare oder auslesbare Speicherzellen oder Speicherzellenbereiche und das Ersetzen dieser Speicherzellen oder Speicherzellenbereiche durch Ersatz-Speicherzellen oder Ersatz-Speicherzellenbereiche mit minimalem Aufwand maximal schnell durchführen.

Ersetzt man nicht verwendbare Speicherzellen oder Speicherzellenbereiche jeweils durch Speicherzellen oder Speicherzellenbereiche, die in der gleichen Speicherzellen-Zeile liegen wie die nicht verwendbaren Speicherzellen oder Speicherzellenbereiche, liest (beim Auslesen von Daten) jeweils alle Speicherzellen einer Speicherzellen-Zeile aus, und läßt (beim Auslesen und beim Einschreiben von Daten) die Auswahleinrichtung festlegen, welcher zur Datenein- und/oder Ausgabe vorgesehene Anschluß der Speichereinrichtung welcher Speicherzelle zugeordnet wird, so können die Überprüfungen und Aktionen, die erforderlich sind, um nicht verwendbare Speicherzellen oder Speicherzellenbereiche ersetzen zu können, sogar ohne oder jedenfalls ohne nennenswerten zusätzlichen Zeitaufwand durchgeführt werden.

Vorteilhafte Weiterbildungen der Erfindung sind den Unteransprüchen, der folgenden Beschreibung und den Figuren entnehmbar.

Die Erfindung wird nachfolgend anhand eines Ausführungsbeispiels unter Bezugnahme auf die Zeichnung näher erläutert.
Es zeigen
- Figur 1: den Aufbau von zum Ersetzen von nicht verwendbaren Speicherzellen oder Speicherzellenbereichen durch Ersatz-Speicherzellen oder Ersatz-Speicherzellenbereiche dienenden Komponenten der nachfolgend näher beschriebenen Speichereinrichtung, und
- Figur 2: den prinzipiellen Aufbau einer Speichereinrichtung der vorliegend betrachteten Art.

Bei der vorliegend betrachteten Speichereinrichtung handelt es sich um einen RAM-Baustein, genauer gesagt um einen DRAM-Baustein. Es sei jedoch bereits an dieser Stelle darauf hingewiesen, daß hierauf keine Einschränkung besteht. Die Speichereinrichtung kann auch eine beliebige andere Speichereinrichtung zum Speichern von Daten sein.

Die nachfolgend näher beschriebene Speichereinrichtung hat den selben prinzipiellen Aufbau wie die eingangs unter Bezugnahme auf Figur 2 beschriebene Speichereinrichtung.

Die betrachtete Speichereinrichtung weist auch wieder mehr Speicherzellen auf, als zur Speicherung einer der verwendbaren Speicherkapazität entsprechenden Datenmenge erforderlich sind, wobei die zusätzlichen Speicherzellen als Ersatz-Speicherzellen oder Ersatz-Speicherzellenbereiche für nicht ordnungsgemäß beschreibbare oder auslesbare Speicherzellen oder Speicherzellenbereiche verwendbar sind.

Die nicht ordnungsgemäß beschreibbaren oder auslesbaren Speicherzellen oder Speicherzellenbereiche werden durch einen Test der Speicherzellen ermittelt. Die Adressen dieser Speicherzellen oder Speicherzellenbereiche werden unter Verwendung von Fuses, im betrachteten Beispiel unter Verwendung von durch einen Laser zerstörbaren Fuses F in der Speichereinrichtung registriert.

Im normalen Betrieb der Speichereinrichtung werden die an diese angelegten Adressen unter Verwendung der Vergleichseinheiten VE mit den in der Speichereinrichtung registrierten Adressen der nicht ordnungsgemäß beschreibbaren oder auslesbaren Speicherzellen oder Speicherzellenbereiche verglichen; die Vergleichseinheiten VE verwenden die Adressen der nicht ordnungsgemäß beschreibbaren oder auslesbaren Speicherzellen oder Speicherzellenbereiche als Referenzadressen, mit denen sie die an die Speichereinrichtung angelegten Adressen vergleichen.

Stellt eine Vergleichseinheit eine Übereinstimmung der zu vergleichenden Adressen fest, so signalisiert sie dies der Auswahleinrichtung AE, welche daraufhin dafür sorgt, daß in die Speichereinrichtung einzuschreibende Daten nicht etwa in die Speicherzellen eingeschrieben werden, die der an die Speichereinrichtung angelegten Adresse zugeordnet sind, sondern in den nicht verwendbaren Speicherzellen zugeordnete (Ersatz-)Speicherzellen, bzw. daß aus der Speichereinrichtung auszulesende Daten nicht etwa aus den Speicherzellen ausgelesen werden, die der an die Speichereinrichtung angelegten Adresse zugeordnet sind, sondern aus den nicht verwendbaren Speicherzellen zugeordneten (Ersatz-)Speicherzellen.

Im betrachteten Beispiel sind pro Speicherblock 16 Vergleichseinheiten vorgesehen. Diese Vergleichseinheiten sind dabei auf je vier Vergleichseinheiten umfassende Vergleichseinheiten-Bänke aufgeteilt. Wie später noch besser verstanden werden wird, werden die Vergleichseinheiten-Bänke vorliegend jeweils einem bestimmten Speicherblock zugeordnet.

Es sei bereits an dieser Stelle darauf hingewiesen, daß auch mehr oder weniger Vergleichseinheiten vorgesehen werden können, und daß die Vergleichseinheiten auch auf mehr oder weniger Vergleichseinheiten umfassende Vergleichseinheiten-Bänke oder überhaupt nicht auf Vergleichseinheiten-Bänke aufgeteilt werden können.

Jeder Vergleichseinheit ist eine eigene Referenzadresse zugeordnet.

Die vorhandenen Vergleichseinheiten arbeiten parallel, so daß die an die Speichereinrichtung angelegten Adressen jeweils gleichzeitig durch alle Vergleichseinheiten mit den diesen zugeordneten Referenzadressen, also gleichzeitig mit allen Referenzadressen verglichen werden.

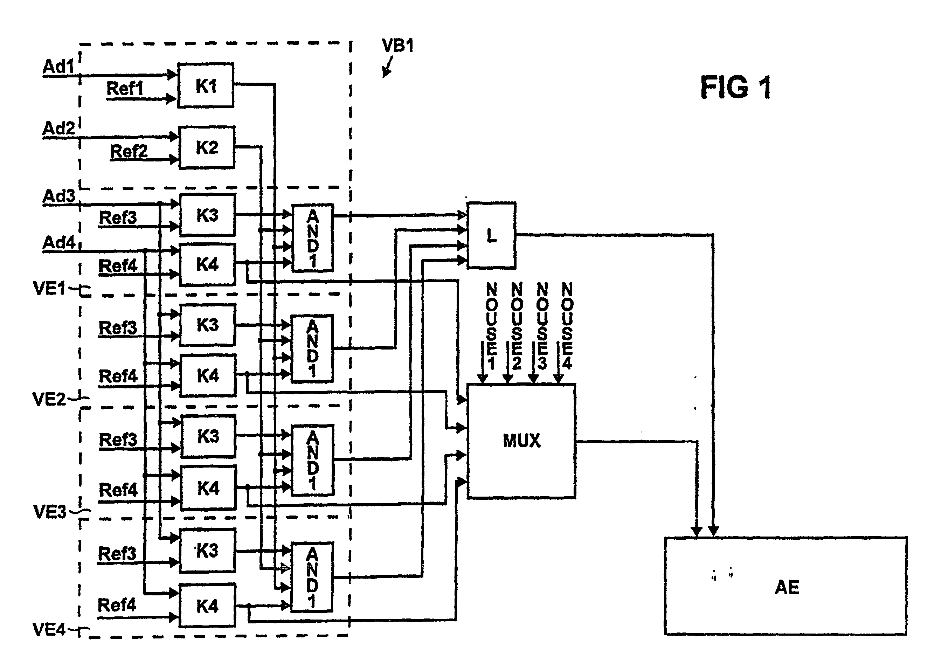

Eine aus vier Vergleichseinheiten bestehende Vergleichseinheiten-Bank und deren Anbindung an die Auswahleinrichtung ist in Figur 1 dargestellt.

Die Vergleichseinheiten sind dabei mit den Bezugszeichen VE1, VE2, VE3 und VE4 bezeichnet, die diese Vergleichseinheiten enthaltende Vergleichseinheiten-Bank mit den Bezugszeichen VB1, und die hierdurch gesteuerte Auswahleinrichtung mit dem Bezugszeichen AE.

Die Vergleichseinheiten-Bank VB1 enthält neben den Vergleichseinheiten VE1 bis VE4 zwei Komparatoren K1 und K2, wobei
- der Komparator K1 überprüft, ob die Speicherbank, die durch die der Speichereinrichtung zugeführte Adresse angesprochen wird, die Speicherbank ist, in welcher sich der Speicherblock befindet, dem die betreffende Vergleichseinheiten-Bank (durch die Referenzadressen, die den darin enthaltenen Vergleichseinheiten zugeordnet sind) zugeordnet ist, und
- der Komparator K2 überprüft, ob der Speicherblock, der durch die der Speichereinrichtung zugeführte Adresse angesprochen wird, derjenige Speicherblock (innerhalb der ausgewählten Speicherbank) ist, dem die betreffende Vergleichseinheiten-Bank (durch die Referenzadressen, die den darin enthaltenen Vergleichseinheiten zugeordnet sind) zugeordnet ist.

Die Vergleichseinheiten VE1 bis VE4 weisen im betrachteten Beispiel einen identischen Aufbau auf. Sie enthalten jeweils Komparatoren K3 und K4 und ein UND-Glied AND1, wobei
- die Komparatoren K3 jeweils überprüfen, ob die Speicherzellen-Spalten, die der der Speichereinrichtung zugeführten Adresse zugeordnet sind, die Speicherzellen-Spalten sind oder sich zumindest teilweise unter den Speicherzellen-Spalten befinden, die der der betreffenden Vergleichseinheit zugeordneten Referenzadresse zugeordnet sind,
- die Komparatoren K4 jeweils überprüfen, ob die Speicherzellen-Zeile, die der der Speichereinrichtung zugeführten Adresse zugeordnet ist, die Speicherzellen-Zeile ist oder sich unter den Speicherzellen-Zeilen befindet, die der der betreffenden Vergleichseinheit zugeordneten Referenzadresse zugeordnet ist bzw. sind, und
- die UND-Glieder AND1 die Ausgangssignale der in den betreffenden Vergleichseinheiten vorgesehenen lokalen Komparatoren K3 und K4 sowie die Ausgangssignale der globalen Komparatoren K1 und K2 einer UND-Operation unterziehen.

Die Ausgangssignale der UND-Glieder AND1 zeigen an, ob die an die Speichereinrichtung angelegte Adresse mit der betreffenden Vergleichseinheit zugeordneten Referenzadresse übereinstimmt. Eine festgestellte Übereinstimmung signalisiert, daß der an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt.

Die Ausgangssignale aller UND-Glieder AND1 einer jeweiligen Vergleichseinheiten-Bank werden einer Logik L zugeführt, und deren Ausgangssignal steuert die bereits erwähnte Auswahleinrichtung AE, welche bei Bedarf dafür sorgt, daß auf den nicht verwendbaren Speicherzellen zugeordnete Ersatz-Speicherzellen zugegriffen wird; die Auswahleinrichtung AE wird veranlaßt, unbrauchbare Speicherzellen oder Speicherzellenbereiche durch Ersatz-Speicherzellen oder Ersatz-Speicherzellenbereiche zu ersetzen, wenn eines der AND1-Ausgangssignale signalisiert, daß die betreffende Vergleichseinheit eine Übereinstimmung zwischen der der Speichereinrichtung zugeführten Adresse und der der Vergleichseinheit zugeordneten Referenzadresse festgestellt hat, und die Auswahleinrichtung AE wird nicht dazu veranlaßt Speicherzellen- oder Speicherzellenbereich-Ersetzungen durchzuführen, wenn keine Übereinstimmung zwischen der der Speichereinrichtung zugeführten Adresse und den Referenzadressen festgestellt wurde.

Die bereits erwähnten Komparatoren K1 bis K4 erhalten als Eingangssignale Ad1 und Ref1 (Komparator K1), Ad2 und Ref2 (Komparator K2), Ad3 und Ref3 (Komparator K3), bzw. Ad4 und Ref4 (Komparator K4), wobei
- Ad1 bis Ad4 Teile der an die Speichereinrichtung angelegten Adresse sind oder daraus extrahiert werden,
- Ref1 bis Ref3 Teile der den Vergleichseinheiten zugeordneten Referenzadressen sind oder daraus extrahiert werden, und im betrachteten Beispiel unter Verwendung von Fuses F in der Speichereinrichtung eingestellt sind, und
- Ref4 ein Teil der den Vergleichseinheiten zugeordneten Referenzadressen ist oder daraus extrahiert wird, und im betrachteten Beispiel bei der Herstellung der Speichereinrichtung fest (unveränderbar) in der Speichereinrichtung eingestellt wird.

Die Eingangssignale Ad1 und Ref1 spezifizieren die Speicherbank, auf die sich die Adressen jeweils beziehen, und umfassen im betrachteten Beispiel jeweils 2 Bits (weil die betrachtete Speichereinrichtung im betrachteten Beispiel vier Speicherbänke umfaßt oder umfassen kann).

Die Eingangssignale Ad2 und Ref2 spezifizieren den Speicherblock innerhalb der ausgewählten Speicherbank, auf den sich die Adressen jeweils beziehen, und umfassen im betrachteten Beispiel ebenfalls jeweils 2 Bits (weil die Speicherbänke jeweils 4 Speicherblöcke umfassen oder umfassen können).

Die Eingangssignale Ad3 und Ref3 spezifizieren die Speicherzellen-Spalten, die den Adressen zugeordnet sind, und umfassen im betrachteten Beispiel ebenfalls jeweils 2 Bits, genauer gesagt die zwei höchstwertigen Bits der Spaltenadressen.

Die Eingangssignale Ad4 und Ref4 spezifizieren die Speicherzellen-Zeile(n), die den Adressen zugeordnet sind, und umfassen im betrachteten Beispiel ebenfalls jeweils 2 Bits, genauer gesagt die zwei höchstwertigen Bits der Zeilenadressen.

Die Eingangssignale Ref4 sind im betrachteten Beispiel so eingestellt, daß unabhängig von der der Speichereinrichtung zugeführten Adresse jeweils genau ein Komparator K4 einer jeden Vergleichseinheiten-Bank eine Übereinstimmung signalisiert, also beispielsweise auf 00 für VE1, auf 01 für VE2, auf 10 für VE3, und auf 11 für VE4.

Dadurch, daß bei den durchzuführenden Vergleichen von den Spaltenadressen und von den Zeilenadressen nur jeweils die zwei höchstwertigen Bits berücksichtigt werden, wird bei den Vergleichen "nur" überprüft, ob die an die Speichereinrichtung angelegte Adresse eine Speicherzelle bezeichnet, die innerhalb eines nicht ordnungsgemäß beschreibbare oder auslesbare Speicherzellen enthaltenden Speicherzellenbereichs liegt. Im betrachteten Beispiel werden also nicht etwa nur einzelne Speicherzellen durch Ersatz-Speicherzellen ersetzt, sondern mehr oder weniger große Speicherzellenbereiche durch Ersatz-Speicherzellenbereiche.

Wie vorstehend bereits mehrfach erwähnt wurde, wird das Ersetzen von nicht verwendbaren Speicherzellen oder Speicherzellenbereichen durch Ersatz-Speicherzellen oder Ersatz-Speicherzellenbereiche von der Auswahleinrichtung AE durchgeführt; die Auswahleinrichtung AE wird hierzu bei Bedarf durch das Ausgangssignal der Logik L veranlaßt.

Der Auswahleinrichtung AE werden neben dem die Speicherzellen- oder Speicherzellenbereich-Ersetzung anstoßenden Signal auch Informationen über die Lage der zu ersetzenden Speicherzellen oder Speicherzellenbereiche zugeführt.

Diese Informationen erhält die Auswahleinrichtung AE von einem Multiplexer MUX, der von den Ausgangssignalen der Komparatoren K4 der Vergleichseinheiten VE1 bis VE4 gesteuert wird.

Der Multiplexer MUX
- schaltet Daten USENOT1 zum Ausgang durch, wenn das Ausgangssignal des Komparators K4 der Vergleichseinheit VE1 eine Übereinstimmung signalisiert,
- schaltet Daten USENOT2 zum Ausgang durch, wenn das Ausgangssignal des Komparators K4 der Vergleichseinheit VE2 eine Übereinstimmung signalisiert,
- schaltet Daten USENOT3 zum Ausgang durch, wenn das Ausgangssignal des Komparators K4 der Vergleichseinheit VE3 eine Übereinstimmung signalisiert, und
- schaltet Daten USENOT4 zum Ausgang durch, wenn das Ausgangssignal des Komparators K4 der Vergleichseinheit VE4 eine Übereinstimmung signalisiert.

Die Daten USENOT1 bis USENOT4 umfassen im betrachteten Beispiel jeweils vier Bit und sind unter Verwendung von Fuses F in der Speichereinrichtung eingestellt. Sie geben an, welche Speicherzellen oder Speicherzellenbereiche innerhalb der Speicherzellen-Zeile, in die Daten geschrieben werden sollen, oder aus der Daten ausgelesen werden sollen, durch Ersatz-Speicherzellen oder Ersatz-Speicherzellenbereiche ersetzt werden sollen.

Dadurch, daß der Auswahleinrichtung AE Informationen über die Lage der nicht zu verwendenden Speicherzellen oder Speicherzellenbereiche zugeführt werden, weiß diese, welche Speicherzellen oder Speicherzellenbereiche beim momentanen Schreiboder Auslesevorgang durch Ersatz-Speicherzellen oder Ersatz-Speicherzellenbereiche ersetzt werden müssen.

Durch welche Ersatz-Speicherzellen oder Ersatz-Speicherzellenbereiche die durch USENOT1, USENOT2, USENOT3 bzw. USENOT4 spezifizierten Speicherzellen oder Speicherzellenbereiche ersetzt werden, kann die Auswahleinrichtung AE im betrachteten Beispiel selbst bestimmen. In der Auswahleinrichtung AE existiert im betrachteten Beispiel nämlich eine Vorschrift über die Zuordnung zwischen den Lagen der zu ersetzenden Speicherzellen bzw. Speicherzellenbereiche und den zu verwendenden Ersatz-Speicherzellen bzw. Ersatz-Speicherzellenbereichen.

Die Auswahleinrichtung AE könnte selbstverständlich auch anders in den Besitz der Information über die Lage der zu verwendenden Ersatz-Speicherzellen oder Ersatz-Speicherzellenbereiche gelangen. Beispielsweise könnten ihr diese Informationen wie die Informationen über die Lage der zu ersetzenden Speicherzellen oder Speicherzellenbereiche zugeführt werden.

Mit den der Auswahleinrichtung AE verfügbaren Informationen ist diese in der Lage, nicht verwendbare Speicherzellen oder Speicherzellenbereiche selbständig durch Ersatz-Speicherzellen oder Ersatz-Speicherzellenbereiche zu ersetzen.

Im betrachteten Beispiel
- liegen die Ersatz-Speicherzellen oder Ersatz-Speicherzellenbereiche jeweils in der selben Speicherzellen-Zeile wie die zu ersetzenden Speicherzellen oder Speicherzellenbereiche,
- werden beim Auslesen jeweils alle Speicherzellen (einschließlich der Ersatz-Speicherzellen) einer Speicherzellen-Zeile ausgelesen, und
- wird durch die Auswahleinrichtung AE die Zuordnung zwischen den zur Dateneingabe und/oder Datenausgabe dienenden Datenein- und/oder Ausgabeanschlüssen D1 bis Dm und den zu beschreibenden oder auszulesen Speicherzellen festgelegt.

Deshalb, und weil die Informationen über die Lage der zu ersetzenden Speicherzellen und Speicherzellenbereiche der Auswahleinrichtung bereits zugeführt werden, bevor die Speicherzellen oder Speicherzellenbereich-Ersetzung durch das Ausgangssignal der Logik L angestoßen wird, können die Feststellung der Notwendigkeit und die Durchführung der Ersetzung von nicht ordnungsgemäß beschreibbaren oder auslesbaren Speicherzellen oder Speicherzellenbereichen durch Ersatz-Speicherzellen oder Ersatz-Speicherzellenbereiche ohne oder jedenfalls ohne nennenswerte Verzögerung des Beschreibens oder Auslesens der Speichereinrichtung erfolgen.

Das Zuführen der Informationen über die Lage der zu ersetzenden Speicherzellen oder Speicherzellenbereiche erfolgt im betrachteten Beispiel abhängig von den Ausgangssignalen der Komparatoren K4, also bereits zu einem Zeitpunkt, zu dem noch nicht feststeht, daß der an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt. Die Übermittlung der Information über die Lage der zu ersetzenden Speicherzellen oder Speicherzellenbereiche erfolgt zu einem möglichst frühen Zeitpunkt: immer betrachteten Beispiel, sobald nicht mehr ausgeschlossen werden kann, daß der an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt.

Dadurch kann die Auswahleinrichtung AE eine ggf. durchzuführende Ersetzung unmittelbar nach der Veranlassung der Ersetzung durch das Ausgangssignal der Logik L durchgeführt werden; die Auswahleinrichtung AE muß nicht warten, bis ihr die zur Durchführung der Ersetzung benötigten Information über die Lage der zu ersetzenden Speicherzellen oder Speicherzellenbereiche vorliegen oder gültig sind.

Von den Komparatoren K4 der Vergleichseinheiten einer Vergleichseinheiten-Bank kann durch die Festlegung von Ref4 nur einer eine Übereinstimmung signalisieren. Dadurch kann es im Multiplexer MUX nicht zu Konflikten kommen. Für jede Vergleichseinheiten-Bank ist ein eigener Multiplexer MUX vorgesehen. Jeder Multiplexer MUX führt der (für alle Vergleichseinheiten-Bänke gemeinsamen) Auswahleinrichtung AE Informationen über die Lage von zu ersetzenden Speicherzellen oder Speicherzellenbereichen zu; die Auswahleinrichtung AE hat entsprechend viele Anschlüsse.

Die Zuführung von Informationen über die Lage von zu ersetzenden Speicherzellen oder Speicherzellenbereichen zur Auswahleinrichtung AE bewirkt in der Auswahleinrichtung noch nicht, daß entsprechende Ersetzungen durchgeführt werden. Dies ist erst dann der Fall, wenn die Auswahleinrichtung AE durch ein Ausgangssignal einer Logik L dazu angestoßen wird.

Es ist für jede Vergleichseinheiten-Bank eine Logik L vorgesehen. Jede Logik L führt der (für alle Vergleichseinheiten-Bänke gemeinsamen) Auswahleinrichtung AE ihr Ausgangssignal zu; die Auswahleinrichtung hat entsprechend viele Anschlüsse.

Durch die Ausgangssignale der Logiken L wird bestimmt, ob Ersetzungen von Speicherzellen oder Speicherzellenbereichen durchzuführen sind, und unter Berücksichtigung welcher MUX-Ausgangssignale diese zu erfolgen haben; die Auswahleinrichtung verwendet jeweils das Ausgangssignal des Multiplexers MUX, der der Vergleichseinheiten-Bank zugeordnet ist, von welcher das die Auswahleinrichtung AE zur Speicherzellenoder Speicherzellenbereich-Ersetzung veranlassende Signal stammt.

Bei einer wie beschrieben aufgebauten Speichereinrichtung lassen sich das Erkennen von Zugriffen auf nicht ordnungsgemäß beschreibbare oder auslesbare Speicherzellen oder Speicherzellenbereiche und das Ersetzen dieser Speicherzellen oder Speicherzellenbereiche durch Ersatz-Speicherzellen oder Ersatz-Speicherzellenbereiche mit minimalem Aufwand maximal schnell bewerkstelligen.

## Patentansprüche

1. Speichereinrichtung mit einer Vielzahl von Speicherzellen zum Speichern von Daten, mit mindestens einer Vergleichseinheit (VE), durch welche überprüfbar ist, ob einer an die Speichereinrichtung (S) angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt, und mit einer Auswahleinrichtung (AE), welche bei Bedarf dafür sorgt, daß anstelle von nicht ordnungsgemäß beschreibbaren oder auslesbaren Speicherzellen oder Speicherzellenbereichen Ersatz-Speicherzellen oder Ersatz-Speicherzellenbereiche verwendet werden,
**dadurch gekennzeichnet,**
**daß** der Auswahleinrichtung bereits zu einem Zeitpunkt, zu dem noch nicht feststeht, daß der an die Speichereinrichtung angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt, Informationen über die Lage der nicht zu verwendenden Speicherzellen oder Speicherzellenbereiche zugeführt werden.

2. Speichereinrichtung mit einer Vielzahl von Speicherzellen zum Speichern von Daten, mit mindestens einer Vergleichseinheit (VE), durch welche überprüfbar ist, ob einer an die Speichereinrichtung (S) angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt, und mit einer Auswahleinrichtung (AE), welche bei Bedarf dafür sorgt, daß anstelle von nicht ordnungsgemäß beschreibbaren oder auslesbaren Speicherzellen oder Speicherzellenbereichen Ersatz-Speicherzellen oder Ersatz-Speicherzellenbereiche verwendet werden,
**dadurch gekennzeichnet,**
**daß** der Auswahleinrichtung bereits vor dem Zeitpunkt, zu dem sie veranlaßt wird, dafür zu sorgen, daß anstelle von nicht ordnungsgemäß beschreibbaren oder auslesbaren Speicherzellen oder Speicherzellenbereichen Ersatz-Speicherzellen oder Ersatz-Speicherzellenbereiche verwendet werden, Informationen über die Lage der nicht zu verwendenden Speicherzellen oder Speicherzellenbereiche zugeführt werden.

3. Speichereinrichtung nach Anspruch 1 oder 2,
**dadurch gekennzeichnet,**
**daß** die Auswahleinrichtung (AE) jeweils nur dann dafür sorgt, daß anstelle von nicht ordnungsgemäß beschreibbaren oder auslesbaren Speicherzellen oder Speicherzellenbereichen Ersatz-Speicherzellen oder Ersatz-Speicherzellenbereiche verwendet werden, wenn sie zuvor dazu veranlaßt wurde, und daß diese Veranlassung jeweils erst dann erfolgt, wenn feststeht, daß der an die Speichereinrichtung (S) angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt.

4. Speichereinrichtung nach einem der vorhergehenden Ansprüche,
**dadurch gekennzeichnet,**
**daß** in der mindestens einen Vergleichseinheit (VE) mehrere Vergleiche durchgeführt werden, und daß die Feststellung, ob einer an die Speichereinrichtung (S) angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt, erst getroffen wird, wenn alle Vergleichsergebnisse vorliegen.

5. Speichereinrichtung nach Anspruch 4,
**dadurch gekennzeichnet,**
**daß** der Auswahleinrichtung (AE) die Informationen über die Lage der nicht zu verwendenden Speicherzellen oder Speicherzellenbereiche zugeführt werden, sobald es aufgrund eines oder mehrerer Vergleichsergebnisse nicht mehr ausgeschlossen werden kann, daß der an die Speichereinrichtung (S) angelegten Adresse eine Speicherzelle zugeordnet ist, die nicht ordnungsgemäß beschreibbar oder auslesbar ist oder in einem nicht ordnungsgemäß beschreibbare oder auslesbare Speicherzellen enthaltenden Speicherzellenbereich liegt.

## Claims

1. Memory device having a multiplicity of memory cells for storing data, having at least one comparison unit (VE), which can check whether an address applied to the memory device (S) has an associated memory cell which cannot be written to or read from properly or is in a memory cell area containing memory cells which cannot be written to or read from properly, and having a selection device (AE) which, when required, ensures that backup memory cells or backup memory cell areas are used instead of memory cells or memory cell areas which cannot be written to or read from properly,
**characterized,**
**in that** information about the location of the memory cells or memory cell areas which are not to be used is actually supplied to the selection device at an instant at which it is not yet definite that the address applied to the memory device has an associated memory cell which cannot be written to or read from properly or is in a memory cell area containing memory cells which cannot be written to or read from properly.

2. Memory device having a multiplicity of memory cells for storing data, having at least one comparison unit (VE), which can check whether an address applied to the memory device (S) has an associated memory cell which cannot be written to or read from properly or is in a memory cell area containing memory cells which cannot be written to or read from properly, and having a selection device (AE) which, when required, ensures that backup memory cells or backup memory cell areas are used instead of memory cells or memory cell areas which cannot be written to or read from properly,
**characterized,**
**in that** information about the location of the memory cells or memory cell areas which are not to be used is actually supplied to the selection device before the instant at which it is prompted to ensure that backup memory cells or backup memory cell areas are used instead of memory cells or memory cell areas which cannot be written to or read from properly.

3. Memory device according to Claim 1 or 2,
**characterized**
**in that** the selection device (AE) only ever ensures that backup memory cells or backup memory cell areas are used instead of memory cells or memory cell areas which cannot be written to or read from properly if it has previously been prompted to do so, and in that this prompt only ever comes when it is definite that the address applied to the memory device (S) has an associated memory cell which cannot be written to or read from properly or is in a memory cell area containing memory cells which can not be written to or read from properly.

4. Memory device according to one of the preceding claims,
**characterized**
**in that** the at least one comparison unit (VE) carries out a plurality of comparison operations, and in that the circumstance of whether an address applied to the memory device (S) has an associated memory cell which cannot be written to or read from properly or is in a memory cell area containing memory cells which cannot be written to or read from properly is determined only when all the comparison results are present.

5. Memory device according to Claim 4,
**characterized**
**in that** the information about the location of the memory cells or memory cell areas which are not to be used is supplied to the selection device (AE) as soon as one or more comparison results mean that it is no longer possible to rule out the address applied to the memory device (S) having an associated memory cell which cannot be written to or read from properly or is in a memory cell area containing memory cells which cannot be written to or read from properly.

## Revendications

1. Dispositif de mémoire comprenant une pluralité de cellules de mémoire pour mémoriser des données, comprenant au moins une unité (VE) de comparaison, par laquelle on peut vérifier s'il est associé à une adresse appliquée au dispositif (S) de mémoire une cellule de mémoire dans laquelle on ne peut pas écrire ou lire correctement ou qui se trouve dans une zone de cellules de mémoire contenant des cellules de mémoire dans lesquelles on ne peut pas écrire ou lire correctement, et comprenant un dispositif (AE) de sélection qui, en cas de besoin, sert à utiliser au lieu de cellules de mémoire ou de zones de cellules de mémoire dans lesquelles on ne pas écrire ou lire correctement, des cellules de mémoire de remplacement ou des zones de cellules de mémoire de remplacement,
**caractérisé**
**en ce qu'**il est envoyé au dispositif de sélection, dès un instant où il n'est pas encore certain qu'il est associé à l'adresse appliquée au dispositif de mémoire une cellule de mémoire dans laquelle on ne peut pas écrire ou lire d'une manière correcte ou une zone de cellules de mémoire contenant des cellules de mémoire dans lesquelles on ne peut pas écrire ou lire d'une manière correcte, des informations sur la position des cellules de mémoire ou des zones de cellules de mémoire qui ne peuvent pas être utilisées.

2. Dispositif de mémoire comprenant une pluralité de cellules de mémoire pour mémoriser des données, comprenant au moins une unité (VE) de comparaison, par laquelle on peut vérifier s'il est associé à une adresse appliquée au dispositif (S) de mémoire une cellule de mémoire dans laquelle on ne peut pas écrire ou lire d'une manière correcte ou qui se trouve dans une zone de cellules de mémoire contenant des cellules de mémoire dans lesquelles on ne peut pas écrire ou lire d'une manière correcte, et comprenant un dispositif (AE) de sélection qui, en cas de besoin, sert à utiliser, au lieu de cellules de mémoire ou de zones de cellules de mémoire dans lesquelles on ne pas écrire ou lire d'une manière correcte, des cellules de mémoire de remplacement ou des zones de cellules de mémoire de remplacement,
**caractérisé**
**en ce qu'**il est envoyé au dispositif de sélection des informations sur la position des cellules de mémoire ou des zones de cellules de mémoire qui ne peuvent pas être utilisées dès avant l'instant où il est incité à faire en sorte que soient utilisées, au lieu de cellules de mémoire ou de zones de cellules de mémoire dans lesquelles on ne peut pas écrire ou lire de manière correcte, des cellules de mémoire ou des zones de cellules de mémoire de remplacement.

3. Dispositif de mémoire suivant la revendication 1 ou 2,
**caractérisé**
**en ce que** le dispositif (AE) de sélection fait en sorte que ne soient utilisées des cellules de mémoire de remplacement ou des zones de cellules de mémoire de remplacement au lieu de cellules de mémoire ou de zones de cellules de mémoire dans lesquelles on ne peut pas écrire ou on ne peut pas lire d'une manière correcte que s'il y a été incité auparavant et que cette incitation ne s'effectue respectivement que lorsqu'il est certain qu'il est associé à l'adresse appliquée au dispositif (S) de mémoire une cellule de mémoire dans laquelle on ne peut pas écrire ou lire d'une manière correcte ou dans une zone de cellule de mémoire contenant des cellules de mémoire dans lesquelles on ne peut pas écrire ou lire d'une manière correcte.

4. Dispositif de mémoire suivant l'une des revendications précédentes,
**caractérisé**
**en ce qu'**il est effectué dans la au moins une unité (VE) de comparaison plusieurs comparaisons et que la constatation qu'il est associé à une adresse appliquée au dispositif (S) de mémoire une cellule de mémoire dans laquelle on ne peut pas écrire ou lire d'une manière correcte ou une zone de cellules de mémoire contenant des cellules de mémoire dans lesquelles on ne peut pas lire ou écrire de manière correcte n'a lieu que lorsque l'on dispose de tous les résultats de comparaison.

5. Dispositif de mémoire suivant la revendication 4,
**caractérisé**
**en ce qu'**il est envoyé au dispositif (AE) de sélection les informations sur la position des cellules de mémoire ou des zones de cellules de mémoire qui ne peuvent pas être utilisées dès que, en raison d'un ou de plusieurs résultats de comparaison, il ne peut plus être exclus qu'il est associé à l'adresse appliquée au dispositif (S) de mémoire une cellule de mémoire dans laquelle on ne peut plus écrire ou lire d'une manière correcte ou une zone de cellules de mémoire contenant des cellules de mémoire dans lesquelles on ne peut plus écrire ou lire de manière correcte.
